# EUROPÄISCHE PATENTSCHRIFT

(11) **EP 1 721 027 B1**
(45) Veröffentlichungstag und Bekanntmachung des Hinweises auf die Patenterteilung: **22.07.2015**
(21) Anmeldenummer: 05715359.5
(22) Anmeldetag: 17.02.2005
(51) Int. Cl.: C23C 28/00, C23C 4/04, C23C 4/06, C23C 30/00

(54) **BESCHICHTUNG FÜR EIN SCHNEIDWERKZEUG SOWIE HERSTELLUNGSVERFAHREN**
COATING FOR A CUTTING TOOL AND CORRESPONDING PRODUCTION METHOD
REVETEMENT POUR OUTIL DE COUPE ET PROCEDE DE PRODUCTION CORRESPONDANT

(30) Priorität: 03.03.2004 DE 102004010285
(43) Veröffentlichungstag der Anmeldung: 15.11.2006
(73) Patentinhaber: WALTER Aktiengesellschaft, 72072 Tübingen (DE)
(72) Erfinder: SCHIER, Veit, 70771 Leinfelden (DE)
(74) Vertreter: Rüger, Rudolf
(86) Internationale Anmeldenummer: PCT/EP2005/001584
(87) Internationale Veröffentlichungsnummer: WO 2005/085499

(56) Entgegenhaltungen:
- EP-A- 0 732 423
- EP-A- 1 094 132
- EP-A- 1 195 452
- EP-A1- 1 193 328
- DE-A1- 19 719 195
- US-A1- 2002 039 521

## Beschreibung

Die Erfindung betrifft eine insbesondere für ein Schneidwerkzeug geeignete Beschichtung, ein mit einer solchen Beschichtung versehenes Schneidwerkzeug sowie ein Herstellungsverfahren zur Erzeugung der betreffenden Beschichtung.

Schneidwerkzeuge werden zur Erhöhung der Zerspanungsleistung, der Standzeit oder aus anderen Gründen regelmäßig mit Beschichtungen versehen, die die jeweils gewünschten Eigenschaften realisieren. Beispielsweise ist aus der DE 100 48 899 A1 ein Schneidwerkzeug in Form einer Schneidplatte bekannt, das eine verschleißmindernde Beschichtung aufweist. Diese ist beispielsweise durch eine Al₂O₃-Schicht gebildet. Die verschleißmindernde Beschichtung erstreckt sich sowohl über Spanflächen als auch über Freiflächen des Schneidwerkzeugs. An den Freiflächen ist eine Indikatorbeschichtung, beispielsweise in Form einer Deckschicht angebracht, deren Farbe sich von der Farbe der Verschleißschutzschicht deutlich unterscheidet. An der Freifläche eintretender Abtrag der Dekorschicht ist somit ein untrüglicher Indikator für eine erfolgte Benutzung der betreffenden benachbarten Schneidkante. Die Schichten werden im CVD-Verfahren ganzflächig erzeugt während die Dekorschicht von den Spanflächen abgetragen wird. Dazu können geeignete Bürstverfahren oder ähnliches dienen. Beim mechanischen Entfernen der Dekorschicht von den Spanflächen muss darauf geachtet werden, eine gute Selektivität zu erreichen. Beschädigungen der Verschleißschutzschicht können nicht hingenommen werden.

Schneidplatten die im PVD-Verfahren hergestellt werden weisen in der Regel als Verschleißschutzschicht eine metallische Hartstoffschicht, wie beispielsweise eine TiAlN-Schicht auf. Eine solche Schneidplatte ist beispielsweise aus der DE 199 24 422 C2 bekannt. Auf einer solchen Verschleißschutzschicht aufgebrachte Deckschichten, wie beispielsweise TiB₂-Schichten oder dergleichen weisen, wie die Verschleißschutzschicht, eine metallisch-kristalline Struktur auf. Die Haftung zwischen solchen Deckschichten und der Verschleißschutzschicht ist hoch. Die tribologischen Eigenschaften der Deckschichten müssen deshalb, wenn sie als Dekorschichten verwendet werden, berücksichtigt werden. Sie eignen sich auch nicht als Verschleißindikator.

Durch die feste Haftung der Schichten aneinander muss die Deckschicht hinsichtlich der Verschleißbeanspruchung hinsichtlich ihrer Reibeigenschaften und hinsichtlich sonstiger, sich bei der Metallzerspanung auswirkender, Eigenschaften abgestimmte Eigenschaften aufweisen.

EP 0 732 423 beschreibt eine auf einen Grundkörper eines Schneidwerkzeugs aufgebrachte Beschichtung. Die Beschichtung umfasst eine Innenschicht, die beispielsweise ein Karbid, Karbonitrid, Karbonoxid, Karbostickoxid oder ein Bornitrid aus Titan aufweist. Auf der Innenschicht ist eine Zwischenschicht aus Aluminiumoxid und/oder Zirkonoxid aufgebracht. Die Außenschicht, die wiederum auf die Zwischenschicht aufgebracht ist, kann z.B. ein Karbid, Karbonitrid, Karbonoxid, Karbostickoxid oder ein Bornitrid aus Titan aufweisen. Das Aluminiumoxid bzw. das Zirkonoxid der Zwischenschicht ist ein guter Wärmeisolator und begrenzt bzw. reduziert die Wärmemenge, die von der Außenschicht in den Grundkörper übertragen wird. Die Außenschicht ist ausreichend dick, um einen geringen Verschleiß aufzuweisen, während die Innenschicht eine stabile Verbindung der Beschichtung zum Grundkörper gewährleistet.

Aus US 2002/0039521 ist ein Schneideinsatz mit einer Beschichtung bekannt, die auf einen Grundkörper aufgebracht ist. Die Beschichtung besteht aus einer Aluminiumoxid enthaltenden Verschleißschutzschicht und einer darauf aufgebrachten Deckschicht. Eine Trennschicht ist nicht vorhanden.

Eine mehrlagige Beschichtung für ein Schneidwerkzeug ist außerdem aus EP 1 094 132 A1 bekannt. Dort ist eine Verschleißschutzschicht auf ein Substrat aufgebracht. Die äußerste Schicht bildet eine Deckschicht. Zwischen der Deckschicht und der Verschließschutzschicht ist eine die Haftung der Deckschicht reduzierende Trennschicht vorhanden.

Davon ausgehend ist es Aufgabe der Erfindung, eine zur Herstellung im PVD-Verfahren geeignete Beschichtung anzugeben, deren Deckschicht sich als Verschleißindikator eignet.

Die erfindungsgemäße Beschichtung gemäß Anspruch 1 oder 2, enthält als Verschleißschutzschicht eine metallische Hartstoffschicht, die nach außen hin von einer reduziert haftenden oder durch eine Trennschicht in ihrer Haftung zur Verschleißschutzschicht eingeschränkte Deckschicht abgedeckt ist. Die Deckschicht nimmt dabei nur einen Teil der Fläche der metallischen Hartstoffschicht ein, d.h. Teile derselben sind freigelegt. Zwischen der Deckschicht und der metallischen Hartstoffschicht ist eine Trennschicht angeordnet, die den metallisch-kristallinen Verbund zwischen der Deckschicht und der Verschleißschutzschicht unterbricht oder schwächt. Es handelt sich um eine haftungsstörende oder -mindernde Schicht, die die metallisch-kristalline Struktur der sonstigen Schichten unterbricht oder zumindest stört.

Die Trennschicht vermindert die Haftung der Deckschicht auf der metallischen Hartstoffschicht, die als Verschleißschutzschicht dient, auf ein geringes Maß. Die Trennschicht ist hierfür unstöchiometrisch zusammengesetzt oder ist eine verspannte Schicht mit einer inneren Zugspannung mit einem Betrag von etwa 0,8 GPa. Dadurch kann die Deckschicht relativ leicht abgetragen werden. Dies ermöglicht zum einen, die Deckschicht als Dekorschicht rein nach ästhetischen Gesichtspunkten auszulegen, wobei die tribologischen Eigenschaften sowie die Verschleißeigenschaften keine Rolle spielen. Sie wird beim Einsatz des Schneidwerkzeugs alsbald abgetragen. Somit eröffnet sich auch die Möglichkeit des Einsatzes der Deckschicht als Verschleißindikationsschicht. Dies gilt insbesondere wenn sich die als Verschleißschutzschicht dienende metallische Hartstoffschicht und die Deckschicht farblich deutlich unterscheiden.

Die Verschleißschutzschicht ist vorzugsweise eine im PVD-Verfahren erzeugte Schicht, wobei auch die Trennschicht und die Deckschicht im PVD-Verfahren erzeugt werden. Dies ermöglicht die Herstellung der Beschichtung in einem einzigen PVD-Beschichtungsvorgang, wobei die Deckschicht vorzugsweise einschließlich der Trennschicht in einem mechanischen Nachbearbeitungsvorgang abgetragen werden. Die Nachbearbeitung kann durch Bürsten, Sandstrahlen oder ähnliches erfolgen. Es werden durch die Wirkung der Trennschicht Abtragezeiten von wenigen Sekunden angewendet. Beispielsweise werden durch Abstrahlen mit Aluminiumoxid (Edelkorund) bei einem Druck von lediglich einem Bar und einer Strahlzeit von lediglich zwei Sekunden eine so vollständige Abtragung einer TiN-Deckschicht von z.B. 0,2 µm erreicht, dass optisch auch bei zehnfacher Vergrößerung der Oberfläche keine Reste der Deckschicht mehr zu erkennen sind. Die Verschleißschutzschicht (metallische Hartstoffschicht) wird bei derart kurzer Belastung kaum angegriffen.

Die Haftung der Deckschicht ist immerhin ausreichend, um eine sichere Handhabung der Schneidwerkzeuge ohne Beschädigung der Deckschicht zu ermöglichen. Ein erster Einsatz des Schneidwerkzeugs wird aber sofort durch partiellen Abtrag der Deckschicht erkennbar. Die Deckschicht dient in diesem Fall als Einsatzindikator, der beim ersten Einsatz des Werkzeugs anspricht.

Als Deckschicht eignen sich beispielsweise Titan- oder Hafniumschichten sowie oxidische (heteropolare) Schichten wie z.B. TiO₂. Auch andere Oxide, Carbide oder Nitride von Metallen der vierten oder fünften Nebengruppe sind geeignet. Es werden Deckschichten mit metallisch-kristalliner Struktur bevorzugt. Die Trennschicht hingegen weist z.B. keinen metallisch-kristallinen Aufbau auf. Dies kann erreicht werden, indem als Trennschicht eine Oxidschicht eines Nebengruppenmetalls, vorzugsweise der vierten oder fünften Nebengruppe Anwendung findet. Gute Ergebnisse ergeben dünne Lagen von beispielsweise etwa 0,1 µm TiO₂ TiCN-Schichten oder andere CN-Schichten, die extrem weich und reibarm sind. Gute Ergebnisse werden auch mit MOS₂-Schichten erreicht. Erfindungsgemäß ist die Trennschicht eine extrem unstöchiometrische Schichtoder auch eine extrem verspannte Schicht, die die Haftung zwischen Deckschicht und Verschleißschutzschicht beschränkt. Es können verspannte TiN-Schichten oder auch DLC-Schichten (diamond like carbon) zur Anwendung kommen. Die Auswahl der jeweils geeigneten Trennschicht richtet sich danach, dass sie möglichst ohne Zusatzaufwand in den PVD-Abscheidevorgang zur Herstellung der gesamten Beschichtung integriert werden kann. Die Trennschicht bildet gewissermaßen eine 'Sollbruchstelle' für eventuelle über ihr liegende Schichten.

Die Verschleißschutzschicht (metallische Hartstoffschicht) kann im einfachsten Fall einen einschichtigen Aufbau aufweisen. Bedarfsweise kann auch ein mehrschichtiger Aufbau zur Anwendung kommen.

Die vorgestellte Beschichtung lässt sich im PVD-Verfahren ohne großen Aufwand herstellen, wobei die abgeschiedene Deckschicht nachträglich mechanisch leicht entfernt werden kann. Dadurch wird die Herstellung mehrfarbiger Schneidwerkzeuge auf einfache und rationelle Weise möglich. Unter Schneidwerkzeugen werden hier sowohl vollständige Schneidwerkzeuge, wie Vollhartmetallbohrer, Fräswerkzeuge und dergleichen, wie auch lediglich Schneidplatten, Wendeschneidplatten, Schneideinsätze und dergleichen verstanden.

Weitere vorteilhafte Einzelheiten von Weiterbildungen der Erfindung sind Gegenstand der Zeichnung, der Beschreibung, oder von Ansprüchen. In der Zeichnung ist ein Ausführungsbeispiel der Erfindung veranschaulicht. Es zeigen:
- Figur 1: ein erfindungsgemäßes Schneidwerkzeug in schematisierter Perspektivdarstellung,
- Figur 2: eine ausschnittsweise Schnittdarstellung durch das Schneidwerkzeug nach Figur 1,
- Figur 3: ein Schneidwerkzeug nach durchlaufener PVD-Beschichtung in quer geschnittener, nicht maßstäblicher schematischer Darstellung,
- Figur 4: das Schneidwerkzeug nach Figur 3 nach dem partiellen Abtragen einer Deckschicht und der darunter liegenden Trennschicht in schematisierter Schnittdarstellung und
- Figur 5: einen beispielhaften Spannungsverlauf bezüglich der in den verschiedenen Schichten herrschenden Spannungen des Schneidwerkzeugs als Diagramm.

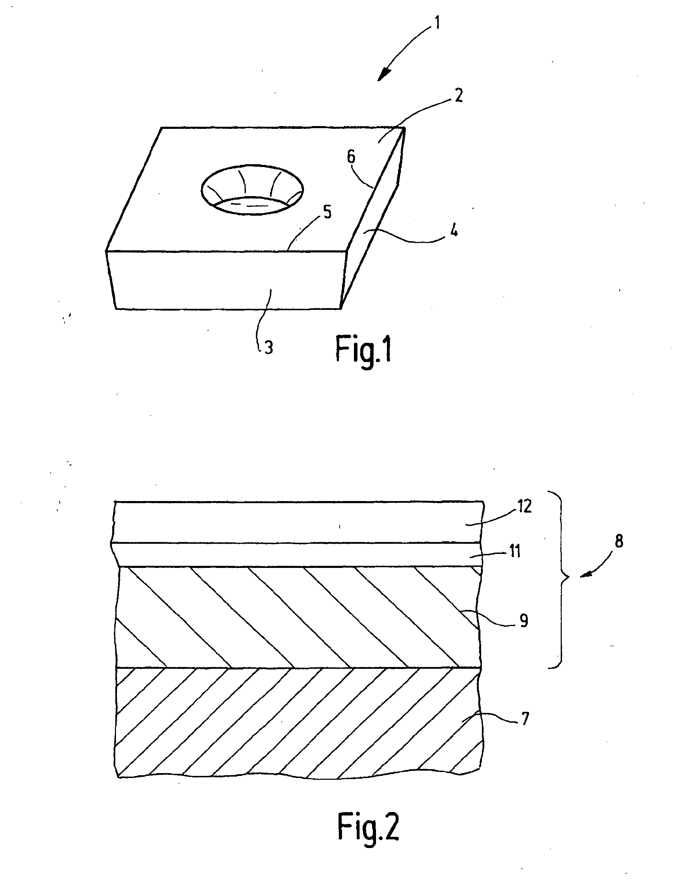

In Figur 1 ist eine Schneidplatte 1 als Schneidwerkzeug oder zumindest wesentlicher Teil desselben veranschaulicht. Die Schneidplatte 1 weist eine Deckfläche auf, die eine Spanfläche 2 bildet, sowie Seitenflächen, die Freiflächen 3, 4 bilden. Diese Bezeichnung gilt für radialen Einbau der Schneidplatte 1. Bei tangentialem oder lateralem Einbau dienen die Seitenflächen als Spanflächen während die Deckfläche als Freifläche dient. Zwischen der Spanfläche 2 und den Freiflächen 3, 4 sind Schneidkanten 5, 6 ausgebildet.

Die Schneidplatte 1 ist eine Hartmetallschneidplatte. Figur 2 veranschaulicht den Querschnitt derselben ausschnittsweise und in extrem vergrößerter Darstellung. Danach weist die Schneidplatte 1 einen Grundkörper 7 auf, dessen Oberfläche das Substrat für eine an der Schneidplatte 1 vorgesehene Beschichtung 8 bildet. Die Beschichtung 8 ist im PVD-Verfahren aufgebracht. Als innere unmittelbar an das Substrat grenzende Schicht ist eine Verschleißschutzschicht 9 vorgesehen, als metallische Hartstoffschicht MH ausgebildet ist. Eine solche ist beispielsweise eine TiAlN-Schicht (Titanaluminiumnitrit), die metallische Eigenschaften aufweist. Sie haftet fest auf dem Grundkörper 7, der beispielsweise aus einem Hartmetall, wie Wolframcarbid mit Kobalt, besteht. Die Dicke der TiAlN-Schicht kann zweckentsprechend festgelegt werden. Im vorliegenden Ausführungsbeispiel liegt sie bei etwa 4 µm. Das Verhältnis zwischen Titan und Aluminium liegt bei 33:67.

Auf die Verschleißschutzschicht 9 ist eine Trennschicht 11 aufgebracht, die den metallischen Haftungsverbund zu einer darüber liegenden Deckschicht 12 unterbricht. Die Deckschicht 12 ist vorzugsweise wiederum eine metallisch-kristalline Schicht, wie beispielsweise eine TiN-Schicht. Die Dicke derselben liegt z.B. bei 0,2 µm. In diesem Fall handelt es sich um eine reine Dekorschicht mit goldgelber Farbe. Diese Farbe ist deutlich von der Farbe der Verschleißschutzschicht 9 unterschieden, die eine andere Farbe aufweist.

Die Trennschicht 11 ist beispielsweise eine Titandioxidschicht (TiO₂), die relativ dünn gewählt werden kann. Es genügt beispielsweise eine Dicke von 0,1 µm. Diese Oxidschicht weist keinen metallischen Charakter auf und limitiert somit die Haftung der Deckschicht 12 an der Verschleißschutzschicht 9. Die angegebene Beschichtung 8 kann in ein und demselben Reaktionsgefäß einer PVD-Beschichtungsanlage in einem Zuge hergestellt werden, wobei die Verschleißschutzschicht 9, die Trennschicht 11 und die Deckschicht 12 nacheinander abgeschieden werden.

Die Trennschicht 11 und die Deckschicht 12 können, wie oben dargestellt, chemisch und/oder strukturell verschiedene Schichten sein. Es ist aber auch möglich, sie zu einer Trenn- und Deckschicht zu vereinigen, deren Besonderheit in der eingeschränkten Haftung zu der Verschleißschutzschicht 9 besteht. Die Trennschicht 11 bildet in diesem Fall zugleich die Deckschicht.

### Die Herstellung erfolgt dabei wie folgt:

Der Grundkörper 7 wird in eine entsprechende PVD-Beschichtungsanlage gebracht, in der zunächst die Verschleißschutzschicht 9, danach die Trennschicht 11 und dann die Deckschicht 12 auf dem Grundkörper 7 abgeschieden werden. Die so erzeugte Beschichtung 8 wird zunächst auf allen exponierten Flächen des Grundkörpers 7 erzeugt, d.h. zumindest an der Spanfläche 2 wie auch an den Freiflächen 3, 4. In diesem Zustand wird die Schneidplatte 1 dem PVD-Reaktorgefäß entnommen.

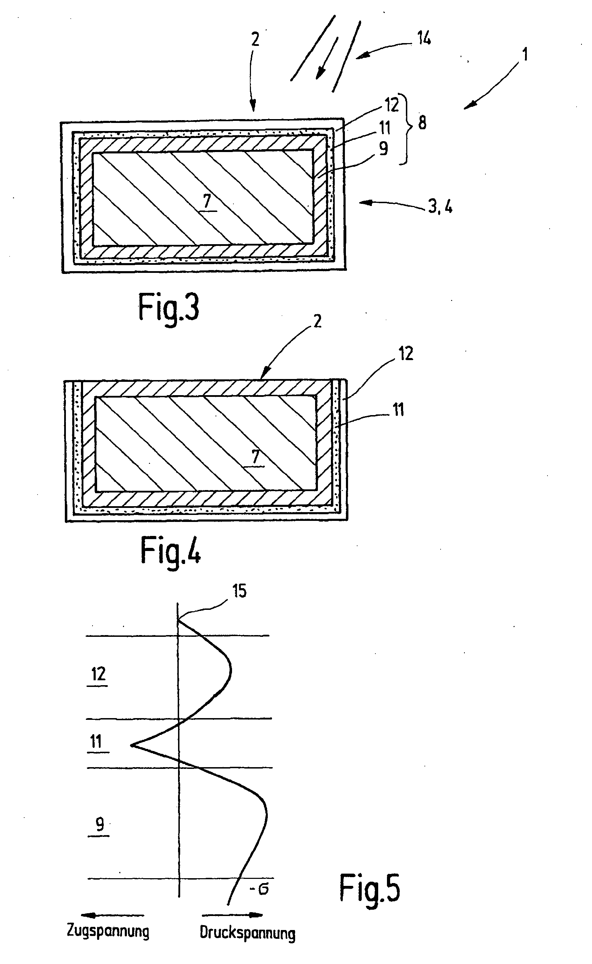

Es werden häufig zweifarbige Schneidplatten gewünscht, die an ihrer Spanfläche 2 eine andere Farbe aufweisen als an den Freiflächen 3, 4. Zur Erzeugung einer solchen wird die Deckschicht 12 von der entsprechend anders farbig auszulegenden Fläche, in diesem Fall der Spanfläche 2, entfernt. Dies kann mit einem Sandstrahl 14 erfolgen, wie er in Figur 3 angedeutet ist. Als Strahlkörper kann Aluminiumoxid (Edelkorund mesh 320) dienen. In einer kurzen Einwirkzeit von beispielsweise 2 Sekunden werden sowohl die Deckschicht 12 als auch die Trennschicht 11 von der Spanfläche 2 ohne sichtbare Reste entfernt. Dies ist in Figur 4 veranschaulicht. Die genannte TiO₂-Trennschicht von 0,1 µm Dicke weist jedoch eine solche Haftung und Festigkeit auf, dass die Deckschicht 12 an Stellen, die nicht unmittelbar von dem Strahl 14 getroffen werden, unbeschädigt erhalten bleibt.

Die Schneidplatte 1 kann in weiteren Ausführungsformen andere Verschleißschutzschichten 9 und andere Deckschichten 12 aufweisen. Jedoch handelt es sich bei der Verschleißschutzschicht 9 jeweils um eine metallische Hartstoffschicht, die im PVD-Verfahren hergestellt ist. Hartstoffschichten ohne Metallstruktur, wie beispielsweise Al₂O₃ sind von der metallischen Hartstoffschicht der Verschleißschutzschicht 9 nicht umfasst. Als Deckschicht kann sowohl die angegebene TiN-Schicht als auch jede andere metallische Deckschicht, wie beispielsweise TiC-Schichten, CrN-Schichten, HfN-Schichten und dergleichen Anwendung finden. Als Trennschicht 11 kann jede vorzugsweise nicht metallische Schicht angewendet werden, die die Haftung zwischen der Deckschicht 12 und der Verschleißschutzschicht 9 beschränkt. Über die im vorigen Ausführungsbeispiel genannte TiO₂-Schicht hinaus, können andere oxidische Schichten angewendet werden, die im PVD abscheidbar sind und keine metallische Bindung aufweisen. Insbesondere können hier Oxide der Metalle der vierten und fünften Nebengruppe zur Anwendung kommen. Auch andere, vorwiegend kovalent gebundene, Schichten, wie beispielsweise MCN-Schichten, können Anwendung finden, wobei M für ein beliebiges Metall, vorzugsweise ein Metall der vierten oder fünften Nebengruppe steht. Auch andere kovalent gebundene Schichten, wie MoS₂-Schichten (Molybdändisulfid) oder Kohlenstoffschichten (DLC) können Anwendung finden. Es wird jedoch auch ins Auge gefasst, metallisch gebundene Trennschichten vorzusehen, wie beispielsweise TiN-Schichten. Um bei diesen eine Haftungsbeschränkung zu erzielen, können diese extrem verspannt werden. Verspannung kann beispielsweise durch große Abweichung vom stöchiometrischen Verhältnis erreicht werden. Figur 5 veranschaulicht dazu den Spannungsverlauf in der Verschleißschutzschicht 9, der Trennschicht 11 und der Deckschicht 12 für einen beispielhaften Fall, bei dem eine Haftungsbegrenzung durch eine gegensinnige Verspannung der Trennschicht 11 gegen die Verschleißschutzschicht 9 und die Deckschicht 12 erreicht wird. Die in der Schicht herrschende Spannung ist als Kurve über einer Linie 15 aufgetragen. So betragen die Spannungen in der Verschleißschutzschicht 9, der Trennschicht 11 und der Deckschicht 12 beispielsweise:
Verschleißschutzschicht 9 - bis zu 2 GPa Druckspannung enstpr. -2 GPa,
Trennschicht 11 - ca. 0,8 GPa Zugspannung entspr. 0,8 GPa,
Deckschicht 12 - ca. 1 GPa Druckspannung entspr. -1 GPa.

Vorliegend wird eine Beschichtung insbesondere für Schneidwerkzeuge angegeben, die sich in einem einzigen PVD-Beschichtungsvorgang erzeugen lässt und mit der sich auf einfache Weise zweifarbige Schneidwerkzeuge erzeugen lassen. Zwischen zwei metallischen Hartstoffschichten unterschiedlicher Farbe ist eine Trennschicht 11 angeordnet, die, wie die anderen Schichten, in dem gleichen PVD-Beschichtungsprozess erzeugt worden ist. Sie gestattet das Abtragen der Deckschicht durch Sandstrahlen, Bürsten oder dergleichen mit sehr kurzen Einwirkzeiten.

## Patentansprüche

1. Beschichtung (8) für ein Schneidwerkzeug,
mit einer Verschleißschutzschicht (9), die eine metallisch-kristalline Struktur aufweist,
mit einer Deckschicht (12), die eine metallisch-kristalline Struktur aufweist,
mit einer Trennschicht (11), die wenigstens auf einen Abschnitt der Verschleißschutzschicht (9) aufgebracht und zwischen der Verschleißschutzschicht (9) und der Deckschicht (12) angeordnet ist und die die Haftung der Deckschicht (12) auf der Verschleißschutzschicht (9) mindert,
**dadurch gekennzeichnet, dass** die Trennschicht (11) eine Oxidschicht mit wenigstens einem Metall (M) einer Nebengruppe des chemischen Periodensystems der Elemente ist und dass die Trennschicht (11) unstöchiometrisch zusammengesetzt ist.

2. Beschichtung (8) für ein Schneidwerkzeug,
mit einer Verschleißschutzschicht (9), die eine metallisch-kristalline Struktur aufweist,
mit einer Deckschicht (12), die eine metallisch-kristalline Struktur aufweist,
mit einer Trennschicht (11), die wenigstens auf einen Abschnitt der Verschleißschutzschicht (9) aufgebracht und zwischen der Verschleißschutzschicht (9) und der Deckschicht (12) angeordnet ist und die die Haftung der Deckschicht (12) auf der Verschleißschutzschicht (9) mindert,
**dadurch gekennzeichnet, dass** die Trennschicht (11) eine Zugspannungen aufweisende Schicht ist und die angrenzende Deckschicht (12) sowie die angrenzende Verschleißschutzschicht (9) nur Druckspannungen aufweisen.

3. Beschichtung nach Anspruch 2, **dadurch gekennzeichnet, dass** die Trennschicht (11) eine Zugspannung mit einem Betrag von 0,8 GPa aufweist.

4. Beschichtung nach Anspruch 1 oder 2, **dadurch gekennzeichnet, dass** auf der Trennschicht (11) eine die Deckschicht (12) angeordnet ist, die eine Dekorschicht ist.

5. Beschichtung nach Anspruch 4, **dadurch gekennzeichnet, dass** die Deckschicht (12) eine Farbe aufweist, die sich von der Farbe der Verschleißschutzschicht (9) erkennbar unterscheidet.

6. Beschichtung nach Anspruch 4, **dadurch gekennzeichnet, dass** die Deckschicht (12) eine TiN-, eine TiC-, eine HfC- oder eine HfN-Schicht ist.

7. Beschichtung nach Anspruch 1, **dadurch gekennzeichnet, dass** das Metall (M) ein Element der IV. Nebengruppe, vorzugsweise Titan oder Zirkonium ist.

8. Beschichtung nach Anspruch 1, **dadurch gekennzeichnet, dass** das Metall (M) ein Element der V. Nebengruppe ist.

9. Beschichtung nach Anspruch 1, **dadurch gekennzeichnet, dass** die Trennschicht (11) eine chemische Verbindung mit kovalenter Bindung enthält oder ist.

10. Beschichtung nach Anspruch 1 oder 2, **dadurch gekennzeichnet, dass** die Verschleißschutzschicht (9) eine TiAlN-Schicht oder eine CrAlN-Schicht ist.

11. Beschichtung nach Anspruch 1 oder 2, **dadurch gekennzeichnet, dass** die Verschleißschutzschicht (9) einen einschichtigen Aufbau aufweist.

12. Beschichtung nach Anspruch 1 oder 2, **dadurch gekennzeichnet, dass** die Verschleißschutzschicht (9) einen mehrschichtigen Aufbau aufweist.

13. Verwendung einer Beschichtung nach einem der vorhergehenden Ansprüche an einem Schneidwerkzeug mit einem Grundkörper (7) aus einem Hartstoff.

14. Verwendung nach Anspruch 13, **dadurch gekennzeichnet, dass** die Verschleißschutzschicht (9) wenigstens an einer Freifläche (3) und wenigstens an einer Spanfläche (4) vorgesehen wird, wohingegen die Deckschicht (12) die Freifläche (3) und/oder die Spanfläche (2) nicht oder nur teilweise bedeckt sind.

15. Verfahren zur Herstellung eines Schneidwerkzeug, bei dem auf einen Grundkörper (7) in einem PVD-Beschichtungsverfahren zunächst eine Beschichtung nach einem der Ansprüche 1 bis 12 aufgebracht wird, wonach die Deckschicht (12) mit einem mechanischen Abtragungsverfahren von ausgewählten Oberflächenbereichen entfernt wird.

16. Verfahren nach Anspruch 15, **dadurch gekennzeichnet, dass** die Deckschicht (12) mittels eines Sandstrahlverfahrens entfernt wird.

17. Verfahren nach Anspruch 15, **dadurch gekennzeichnet, dass** alle Schichten der Beschichtung (8) in einem einzigen PVD-Prozess aufgebracht werden.

## Claims

1. Coating (8) for a cutting tool,
with an anti-abrasion protection layer (9), which has a metallic crystalline structure, with a cover layer (12), which has a metallic crystalline structure,
with a separation layer (11), which is applied at least to a section of the anti-abrasion protection layer (9) and is arranged between the anti-abrasion protection layer (9) and the cover layer (12) and which reduces the adhesion of the cover layer (12) on the anti-abrasion protection layer (9),
**characterised in that** the separation layer (11) is an oxide layer with at least one metal (M) of a subgroup of the chemical periodic table of elements, and that the separation layer (11) is of non-stoichiometric composition.

2. Coating (8) for a cutting tool,
with an anti-abrasion protection layer (9), which has a metallic crystalline structure, with a cover layer (12), which has a metallic crystalline structure,
with a separation layer (11), which is applied at least to a section of the anti-abrasion protection layer (9) and is arranged between the anti-abrasion protection layer (9) and the cover layer (12) and which reduces the adhesion of the cover layer (12) on the anti-abrasion protection layer (9),
**characterised in that** the separation layer (11) is a layer having tensile stresses and the adjoining cover layer (12) as well as the adjoining anti-abrasion protection layer (9) have only compressive stresses.

3. Coating according to claim 2, **characterised in that** the separation layer (11) has a tensile stress with a magnitude of 0.8 GPa.

4. Coating according to claim 1 or 2, **characterised in that** a cover layer (12), which is a decorative layer, is arranged on the separation layer (11).

5. Coating according to claim 4, **characterised in that** the cover layer (12) has a colour, which differs noticeably from the colour of the anti-corrosion protection layer (9).

6. Coating according to claim 4, **characterised in that** the cover layer (12) is a TiN, TiC, HfC or an HfN layer.

7. Coating according to claim 1, **characterised in that** the metal (M) is an element of subgroup IV, preferably titanium or zirconium.

8. Coating according to claim 1, **characterised in that** the metal (M) is an element of subgroup V.

9. Coating according to claim 1, **characterised in that** the separation layer (11) contains or is a chemical compound with a covalent bond.

10. Coating according to claim 1 or 2, **characterised in that** the anti-abrasion protection layer (9) is a TiAlN layer or a CrAlN layer.

11. Coating according to claim 1 or 2, **characterised in that** the anti-abrasion protection layer (9) has a single-layered structure.

12. Coating according to claim 1 or 2, **characterised in that** the anti-abrasion protection layer (9) has a multilayered structure.

13. Use of a coating according to one of the preceding claims on a cutting tool with a base body (7) composed of hard material.

14. Use according to claim 13, **characterised in that** the anti-abrasion protection layer (9) is provided at least on a relief flank (3) and at least on a rake face (4), whereas the cover layer (12), the relief flank (3) and/or the rake face (2) are not, or are only partially, covered.

15. Method for the production of a cutting tool, in which a coating according to claims 1 to 12 is firstly applied to a base body (7) using a PVD coating process, after which the cover layer (12) is removed from selected surface regions using a mechanical removal process.

16. Method according to claim 15, **characterised in that** the cover layer (12) is removed by means of a sandblasting process.

17. Method according to claim 15, **characterised in that** all the layers of the coating (8) are applied in a single PVD process.

## Revendications

1. Revêtement (8) pour outil de coupe,
comprenant une couche de protection contre l'usure (9) qui présente une structure métallique-cristalline,
comprenant une couche de couverture (12) qui présente une structure métallique-cristalline,
comprenant une couche de séparation (11) qui est appliquée au moins sur une partie de la couche de protection contre l'usure (9) et est placée entre la couche de protection contre l'usure (9) et la couche de couverture (12) et qui réduit l'adhérence de la couche de couverture (12) à la couche de protection contre l'usure (9),
**caractérisé en ce que** la couche de séparation (11) est une couche d'oxyde comportant au moins un métal (M) d'un sous-groupe de la classification périodique des éléments chimiques et **en ce que** la couche de séparation (11) présente une composition non stoechiométrique.

2. Revêtement (8) pour outil de coupe,
comprenant une couche de protection contre l'usure (9) qui présente une structure métallique-cristalline,
comprenant une couche de couverture (12) qui présente une structure métallique-cristalline,
comprenant une couche de séparation (11) qui est appliquée au moins sur une partie de la couche de protection contre l'usure (9) et est placée entre la couche de protection contre l'usure (9) et la couche de couverture (12) et qui réduit l'adhérence de la couche de couverture (12) à la couche de protection contre l'usure (9),
**caractérisé en ce que** la couche de séparation (11) est une couche présentant des contraintes de traction, et la couche de couverture (12) adjacente ainsi que la couche de protection contre l'usure (9) adjacente ne présentent que des contraintes de compression.

3. Revêtement selon la revendication 2, **caractérisé en ce que** la couche de séparation (11) présente une contrainte de traction d'une valeur de 0,8 GPa.

4. Revêtement selon la revendication 1 ou 2, **caractérisé en ce que** sur la couche de séparation (11) on place la couche de couverture (12) qui est une couche décorative.

5. Revêtement selon la revendication 4, **caractérisé en ce que** la couche de couverture (12) présente une couleur qui se distingue de façon visible de la couleur de la couche de protection contre l'usure (9).

6. Revêtement selon la revendication 4, **caractérisé en ce que** la couche de couverture (12) est une couche en TiN, en TiC, en HfC ou en HfN.

7. Revêtement selon la revendication 1, **caractérisé en ce que** le métal (M) est un élément du sous-groupe IV, de préférence du titane ou du zirconium.

8. Revêtement selon la revendication 1, **caractérisé en ce que** le métal (M) est un élément du sous-groupe V.

9. Revêtement selon la revendication 1, **caractérisé en ce que** la couche de séparation (11) contient ou est un composé chimique à liaison covalente.

10. Revêtement selon la revendication 1 ou 2, **caractérisé en ce que** la couche de protection contre l'usure (9) est une couche de TiaAlN ou une couche de CrAlN.

11. Revêtement selon la revendication 1 ou 2, **caractérisé en ce que** la couche de protection contre l'usure (9) présente une structure monocouche.

12. Revêtement selon la revendication 1 ou 2, **caractérisé en ce que** la couche de protection contre l'usure (9) présente une structure multicouche.

13. Utilisation d'un revêtement selon l'une des revendications précédentes sur un outil de coupe doté d'un corps de base (7) en matériau dur.

14. Utilisation selon la revendication 13, **caractérisée en ce que** la couche de protection contre l'usure (9) est prévue au moins sur une face de dépouille (3) et au moins sur une face de coupe (4), tandis la couche de couverture (12) la face de dépouille (3) et/ou la face de coupe (2) ne sont pas ou seulement partiellement recouvertes.

15. Procédé de fabrication d'un outil de coupe, selon lequel on applique d'abord sur un corps de base (7), au cours d'un processus de revêtement par dépôt physique en phase vapeur, un revêtement selon l'une des revendications 1 à 12, et ensuite on élimine la couche de couverture (12) dans des zones de surface sélectionnées, par un procédé mécanique d'enlèvement de matière.

16. Procédé selon la revendication 15, **caractérisé en ce que** la couche de couverture (12) est éliminée au moyen d'un procédé de sablage.

17. Procédé selon la revendication 15, **caractérisé en ce que** toutes les couches du revêtement (8) sont appliquées au cours d'un seul processus de dépôt physique en phase vapeur.
